Europäisches Patentamt

European Patent Office

Office européen des brevets

(11) Numéro de publication: **0 300 863**
**A1**

# DEMANDE DE BREVET EUROPEEN

(21) Numéro de dépôt: **88401709.6**

(22) Date de dépôt: **01.07.88**

(51) Int. Cl.⁴: **H 01 L 39/24**

(30) Priorité: **03.07.87 FR 8709462**

(43) Date de publication de la demande:
**25.01.89 Bulletin 89/04**

(84) Etats contractants désignés: **DE GB IT NL**

(71) Demandeur: **THOMSON-CSF**
**173, Boulevard Haussmann**
**F-75379 Paris Cédex 08 (FR)**

(72) Inventeur: **Creuzet, Gérard**
**THOMSON-CSF SCPI 19, avenue de Messine**
**F-75008 Paris (FR)**

**Friederich, Alain**
**THOMSON-CSF SCPI 19, avenue de Messine**
**F-75008 Paris (FR)**

(74) Mandataire: **Grynwald, Albert et al**
**THOMSON-CSF SCPI 19, avenue de Messine**
**F-75008 Paris (FR)**

(54) **Procédé de réalisation de dispositifs en couches minces de matériaux supraconducteurs, et dispositifs réalisés par ce procédé.**

(57) L'invention concerne un procédé de réalisation de couches minces de matériaux supraconducteurs et un dispositif supraconducteur.

Selon l'invention on prévoit de réaliser de telles couches par épitaxie, sur un substrat, des différents éléments constituants en réglant l'admission des différents constituants pour obtenir une couche supraconductrice dont le paramètre de maille est sensiblement adapté à celui du substrat. L'épitaxie peut également se faire directement à partir d'un matériau supraconducteur.

Application : réalisation de tout dispositif supraconducteur.

**FIG_1**

EP 0 300 863 A1

Bundesdruckerei Berlin

**Description**

## PROCEDE DE REALISATION DE DISPOSITIFS EN COUCHES MINCES DE MATERIAUX SUPRACONDUCTEURS ET DISPOSITIFS REALISES PAR CE PROCEDE

L'invention concerne un procédé de réalisation de dispositifs en couches minces de matériaux supraconducteurs sur un substrat. Elle concerne des dispositifs en couches minces supraconductrices.

Plus particulièrement l'invention concerne un procédé de préparation de couches minces d'oxydes supraconducteurs à température critique élevée. Les propriétés supraconductrices de ces composés étant intimement dépendantes de la structure cristalline, celle-ci est obtenue directement lors de la croissance par épitaxie sur un substrat approprié.

Les oxydes supraconducteurs révolutionnent le domaine de la supraconductivité et ses applications. La première mise en évidence a été reportée par J.G. Bednorz et K. Muller, dans le document Z. Phys. B 64, 1986, pages 189 à 193, et concernant un composé La-Cu-O dopé au baryum où le début de la transition supraconductrice est observé vers 35K. Le dopage au strontium permet d'élever légèrement cette température et de rendre cette supraconductivité plus massive. Enfin, la substitution du lanthane par l'yttrium a permis l'observation d'une température critique de 93 degrés kelvin, comme cela a été reporté par M.K. Wu et al dans le document Physical. Review. Letters 58, 1987, pages 908 à 910.

L'existence de matériaux supraconducteurs à des températures plus élevées que celle de l'azote liquide (77K) permet de s'affranchir de la nécessité de travailler dans l'Hélium li quide, contrainte pesante qui limitait fortement jusqu'à présent le développement des applications de la supraconductivité. Parmi ces dernières, une large proportion (dispositifs à jonctions, absorbants IR, mémoires, ...) doivent être réalisés à partir de couches minces. La préparation du matériau supraconducteur sous cette forme est donc une étape essentielle.

L'ensemble des oxydes supraconducteurs connus présentent une étroite corrélation entre les propriétés supraconductrices et la structure cristallographique. Celle-ci est toujours de type pérovskite. Dans les systèmes $La_{2-x}Ba_xCuO_{4-y}$ et $La_{2-x}Sr_xCuO_{4-y}$, la structure est de type $K_2NiF_4$ comme cela est décrit par exemple par N. Nguyen, F. Studer et B. Raveau dans le document. Journal. Physical. Chemical. Solids, 44, 1983, pages 389 à 400. Dans le système $YBa_2Cu_3O_{7-y}$ la structure est légèrement différente mais toujours de type perovskite, comme cela est reporté par exemple par T.SIEGRIST et al, Physic Review B 35, 1987, pages 7137 à 7139.

Hormis la structure, l'autre paramètre fondamental pour l'obtention des propriétés supraconductrices dans ces systèmes est la teneur en oxygène, comme on le voit par exemple dans l'article de R.J. Cava et Coll, Phys. Rev. Lett, 58, 1987, pages 408 à 410.

L'ensemble des résultats reportés à ce jour concerne des matériaux préparés sous forme de poudres frittées, que l'on peut décrire comme une juxtaposition de petits grains polycristallins. Le taux approprié en oxygène est obtenu par des recuits sous atmosphère d'oxygène.

L'invention concerne la préparation de ces matériaux sous forme de couches minces épitaxiées sur des substrats choisis de telle sorte que la structure correspondant aux propriétés supraconductrices sera forcée.

L'invention concerne donc un procédé de réalisation de dispositifs en couches minces de matériaux supraconducteurs sur un substrat, caractérisé en ce qu'il comporte une étape de crois sance par épitaxié à partir de flux moléculaires dont les sources sont soit les éléments bruts (La, Ba, Cu ou Y, Ba, Cu par exemple), soit des oxydes de ces éléments, avec des flux tels que l'on obtienne une couche de stoéchiométrie désirée correspondant au matériau massif possédant une supraconductivité à température critique élevée. Ce premier procédé concerne la croissance directe par épitaxie d'une couche monocristalline.

L'invention concerne également un procédé de réalisation de dispositifs en couches minces de matériaux supraconducteurs sur un substrat, caractérisé en ce qu'il comporte les étapes successives suivantes :

- une étape de réalisation d'un matériau solide supraconducteur présentant un paramètre de maille correspondant à un multiple ou à un sous-multiple du paramètre de maille du substrat ;

- une étape e croissance par épitaxie en phase solide, du matériau obtenu au cours de l'étape précédente, sur le substrat.

Enfin l'invention concerne également un dispositif en couches minces de matériaux supraconducteurs réalisé par un procédé précédent, caractérisé en ce qu'il comporte sur un substrat au moins une couche d'un matériau supraconducteur présentant un paramètre de maille correspondant à un multiple ou un sous-multiple du paramètre de maille du substrat.

Les différents objets et caractéristiques de l'invention apparaîtront plus clairement dans la description qui va suivre faite à titre d'exemple en se reportant aux figures annexées qui représentent :

la figure 1, un exemple de réalisation d'un dispositif en couches minces de matériau supraconducteur selon l'invention :

- la figure 2, un exemple de réalisation d'un dispositif en couches minces supraconductrices comportant un super-réseau d'adaptation ;

- la figure 3, des exemples de réalisation de dispositifs en couches minces supraconductrices comportant des couches de protection étanches.

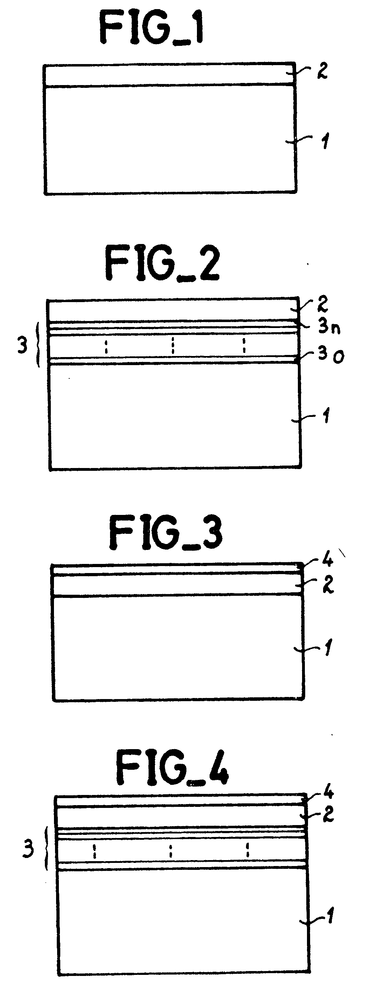

Selon le procédé de l'invention on réalise la croissance par épitaxie d'une couche 2 d'un matériau susceptible de devenir supraconducteur après oxydation sur un substrat 1 tel que représenté en figure 1.

Le matériel permettant de réaliser l'épitaxie est un matériel classique d'épitaxie connu dans la technique. Pour obtenir le dosage adapté des corps constituants, on règle dans un premier temps séparément l'admission de chaque corps puis on épitaxie simultanément l'ensemble des corps.

De plus pour qu'il y ait croissance par épitaxie, le substrat est choisi en fonction du composé final désiré pour qu'il y ait adaptation de mailles, c'est-à-dire que le paramètre de maille de la couche obtenue soit égal au multiple ou au sous-multiple du paramètre de maille du substrat.

L'oxydation de la couche obtenue se fait sous atmosphère d'oxygène à une température de recuit située aux alentours de 900°C, par exemple, selon la nature de la couche mince. La durée de cette oxydation (de plusieurs heures à plusieurs jours) est déterminée de façon à obtenir une composition de la couche telle qu'elle présente une supraconductivité à température élevée.

Selon une variante du procédé de l'invention, l'épitaxie se fait en présence d'un flux local d'oxygène. Le flux d'oxygène reste faible (pression de $10^{-4}$ à $10^{-3}$ torr par exemple) pour rester compatible avec les exigences techniques d'un bati d'épitaxie par jets moléculaires.

Cette épitaxie peut être également complétée par un recuit sous oxygène pour rendre plus précise l'oxydation de la couche.

L'apport d'oxygène peut être également réalisé par recuit sous plasma d'oxygène pour améliorer la diffusion à travers le matériau.

Selon une autre variante du procédé de l'invention la réalisation de la couche mince 2 peut être réalisée en partant d'un matériau solide présentant un effet de supraconductivité désirée et déposer sur le substrat 1 ce matériau solide à l'état amorphe ou partiellement cristallin ; à l'aide d'une technique de dépôt quelconque ; pulvérisation cathodique, jets moléculaires, ou simple évaporation par exemple.

Dans le cadre de cette variante le procédé de l'invention prévoit donc tout d'abord une étape de réalisation d'un matériau ayant une stoechimétrie identique à celle du matériau qui présente l'effet de supraconductivité recherché et possèdant, par ailleurs, un paramètre de maille sensiblement égal à un multiple ou un sous-multiple du paramètre de maille du substrat sur lequel le matériau est déposé.

Cette étape de réalisation du matériau supraconducteur est suivie d'une étape d'épitaxie en phase solide du matériau obtenu sur le substrat 1. Lors de cette phase, à l'aide d'un recuit thermique approprié, le matériau de la couche 2 passe progressivement d'une structure non ordonnée à une structure monocristalline. Cette transformation en phase solide se réalise à partir du substrat 1 qui impose donc structure et paramètre de maille. Ce type d'épitaxie en phase solide est du type utilisé par exemple pour la réalisation de couches de silicium amorphe.

Pour faciliter l'adaptation en maille de la couche mince 2 de matériau semiconducteur et du substrat 1, le procédé de l'invention prévoit également, avant de réaliser l'épitaxie de la couche 2 sur le substrat, une étape de réalisation d'un super-réseau d'adaptation en mailles. Ce super-réseau 3 est réalisé également par épitaxie. Il a pour but de fournir une succession de couches dont les plus proches du substrat 1 ont un paramètre de maille adapté à celui du substrat 1 et les plus éloignées (donc celle qui seront les plus proches de la couche mince 2) auront un paramètre de maille adapté à celui de la couche mince 2. Cette étape de procédé permet de réaliser sur un substrat 1, l'adaptation d'une couche mince 2 dont le paramètre de maille n'est pas adapté naturellement à celui du substrat 1.

Enfin le procédé de l'invention prévoit, après réalisation de la couche mince supraconductrice 2 et après l'éventuelle étape d'oxydation, une étape d'encapsulation de la couche mince 2 supraconductrice.

Cette étape d'encapsulation a pour objet de déposer, sur la couche mince 2 de matériau supraconducteur, une couche d'un matériau imperméable à l'oxygène. Cette étape d'encapsulation se fait après qu'on ait obtenu la stoechiométrie désirée en oxygène de la couche mince 2 de façon à éviter toute dégradation ultérieure.

Cette encapsulation permet, le cas échéant, de réaliser une étape de recuit de cristallisation de la couche mince 2 et cela sans perte d'oxygène. On peut ainsi, dans le cas d'une épitaxie incomplète, procéder dans une étape ultérieure, sur la couche encapsulée, à une épitaxie en phase solide par traitement thermique appropriée.

Sur la figure 1, on trouve ainsi un substrat 1 portant une couche mince 2 d'un matériau supraconducteur présentant un paramètre de maille sensiblement égal à un multiple ou un sous-multiple de celui du substrat 1.

Sur la figure 2, le substrat 1 porte un super-réseau 3 sur lequel est réalisé la couche mince 2 de matériau supraconducteur 2. Ce super-réseau 3 a pour rôle d'adapter le paramètre de maille de la couche mince 2 à celui du substrat 1. Les couches les plus proches du substrat, telle que 30, ont un paramètre de maille sensiblement égal à un multiple ou un sous-multiple du paramètre de maille du substrat 1. Les couches les plus proches de la couche mince 2, telle que 3n, ont un paramètre de maille sensiblement égal à un multiple ou un sous-multiple du paramètre de maille de la couche 2. les couches intermédiaires du super-réseau servent à réaliser d'adaptation progres sive en paramètres de maille nécessitée par les différences de paramètres de mailles.

La figure 3, représente un dispositif comportant sur un substrat 1, une couche mince 2 d'un matériau supraconducteur, l'ensemble étant recouvert d'une couche 4 d'un matériau imperméable à l'oxygène. Cette couche 4 empêche toute variation de la schéochiométrie en oxygène de la couche mince 2.

Enfin la figure 4 représente le dispositif de la figure 2 comprenant un super-réseau 3, l'ensemble étant recouvert comme en figure 3 par une couche d'un matériau étanche à l'oxygène.

Il est bien évident que la description qui précède n'a été faite qu'à titre d'exemple. D'autres variantes peuvent être envisagées sans sortir du cadre de l'invention. Les valeurs numériques, notamment ainsi que les exemples de matériaux utilisés et les procédés de fabrication indiqués n'ont été fournis que pour illustrer la description.

## Revendications

1. Procédé de réalisation de dispositifs en couches minces de matériaux supraconducteurs sur un substrat (1) caractérisé en ce qu'il comporte une étape de croissance par épitaxie de plusieurs matériaux comprenant des oxydes métalliques et des oxydes de terres rares ou des éléments bruts non oxydés avec des flux tels qu'on obtienne une couche (2) dont le matériau possède un paramètre de maille correspondant sensiblement à un multiple ou un sous-multiple du paramètre de mailledu substrat et présentant une supraconductivité à température critique élevée.

2. Procédé de réalisation de dispositifs en couches minces de matériaux supraconducteurs sur un substrat (1), caractérisé en ce qu'il comporte les étapes successives suivantes :

- une étape de dépôt d'un matériau solide à l'état amorphe ou partiellement cristallin sur le substrat 1 ;

une étape d'épitaxie en phase solide, du matériau obtenu au cours de l'étape précédente, sur le substrat (1).

3. Procédé de réalisation selon l'une quelconque des revendications 1 ou 2, caractérisé en ce que la croissance par épitaxie se fait sous un flux d'oxygène.

4. Procédé de réalisation selon l'une quelconque des revendications 1 ou 2, caractérisé en ce que la croissance par épitaxie est suivie d'une étape de recuit sous atmosphère d'oxygène.

5. Procédé de réalisation selon l'une quelconque des revendications 1 ou 2, caractérisé en ce que la croissance par épitaxie est suivie d'une étape de recuit sous plasma d'oxygène.

6. Procédé de réalisation selon l'une quelconque des revendications 1 ou 2, caractérisé en ce que la couche de matériau épitaxiée (2) est recouverte d'une couche (4) de matériau imperméable à l'oxygène.

7. Procédé de réalisation selon l'une quelconque des revendications 1 ou 2, caractérisé en ce que l'étape de croissance par épitaxie est précédée d'une étape de réalisation sur le substrat d'un super-réseau d'adaptation en mailles (3).

8. Dispositif en couches minces de matériaux supraconducteurs réalisé par un procédé selon l'une quelconque des revendications précédentes, caractérisé en ce qu'il comporte sur un substrat (1) au moins une couche (2) d'un matériau supraconducteur présentant un paramètre de maille correspondant à un multiple ou un sous-multiple du paramètre de maille du substat.

9. Dispositif en couches minces de matériaux supraconducteurs selon la revendication 8, caractérisé en ce qu'il comporte une couche (3) d'un matériau imperméable supraconducteur.

10. Dispositif en couches minces matériaux supraconducteurs selon la revendication 8, caractérisé en ce qu'il comporte, entre le substrat (1) et la couche (2) de matériau supraconducteur, un super-réseau d'adaptation (3).

0300863

# FIG_1

# FIG_2

# FIG_3

# FIG_4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | JAPANESE JOURNAL OF APPLIED PHYSICS SUPPLEMENTS 6TH INTERNATIONAL MEETING ON FERROELECTRICITY, 12-16 août 1985, Kobe, vol. 24, no. 2, pages 323-325, Tokyo, JP; T. MURAKAMI et al.: "Single-crystal thin-film growth and properties of BaPb1-xBixO3" * En entier * --- | 1 | H 01 L  39/24 |
| A | LE VIDE, LES COUCHES MINCES, vol. 41, no. 231, mars/avril 1986, pages 239-240, Paris, FR; A. LEYCURAS et al.: "Super réseau à contraintes Ge1-xSix / Ge1-ySiy pour la croissance en adaptation de maille de GaAs sur substrats de silicium" * Résumé * --- | 7,10 | |
| A | PROCEEDINGS OF SYMPOSIUM S 1987 SPRING MEETING OF THE MATERIALS RESEARCH SOCIETY, 23-24 avril 1987, Anaheim, Ca, pages 169-171, US; R.H. HAMMOND et al.: "Superconducting thin films of the perovskite superconductors by electron-beam deposition" --- | | |
| A | PHYSICAL REVIEW B, vol. 35, no. 16, 1er juin 1987, pages 8821-8823, The American Physical Society, New York, US; R.B. LAIBOWITZ et al.: "Thin superconducting oxide films" ----- | | |

**DOMAINES TECHNIQUES RECHERCHES (Int. Cl.4)**

H 01 L  39

Le présent rapport a été établi pour toutes les revendications

| Lieu de la recherche | Date d'achèvement de la recherche | Examinateur |
|---|---|---|
| LA HAYE | 27-10-1988 | PELSERS L. |

EPO FORM 1503 03.82 (P0402)